# EUROPÄISCHE PATENTSCHRIFT

(11) **EP 0 968 535 B1**
(45) Veröffentlichungstag und Bekanntmachung des Hinweises auf die Patenterteilung: **05.09.2007**
(21) Anmeldenummer: 98925423.0
(22) Anmeldetag: 20.03.1998
(51) Int. Cl.: H01L 41/04

(54) **VORRICHTUNG UND VERFAHREN ZUM ANSTEUERN EINES PIEZOGESTEUERTEN KRAFTSTOFFEINSPRITZVENTILS**
DEVICE AND METHOD FOR CONTROLLING A PIEZOREGULATED FUEL INJECTION VALVE
DISPOSITIF ET PROCEDE PERMETTANT DE COMMANDER UNE SOUPAPE D'INJECTION DE CARBURANT A ACTIONNEMENT PIEZOELECTRIQUE

(30) Priorität: 21.03.1997 DE 19711903
(43) Veröffentlichungstag der Anmeldung: 05.01.2000
(73) Patentinhaber: SIEMENS AKTIENGESELLSCHAFT, 80333 München (DE)
(72) Erfinder: EGGER, Klaus, D-93173 Wenzenbach (DE); HOFFMANN, Christian, D-93057 Regensburg (DE); KLÜGL, Wendelin, D-92358 Seubersdorf (DE); FREUDENBERG, Hellmut, D-93080 Pentling (DE); SCHÖPPE, Detlev, D-93173 Wenzenbach (DE)
(86) Internationale Anmeldenummer: PCT/DE1998/000837
(87) Internationale Veröffentlichungsnummer: WO 1998/043305

(56) Entgegenhaltungen:
- EP-A- 0 379 182
- PATENT ABSTRACTS OF JAPAN vol. 013, no. 225 (M-830), 25. Mai 1989 & JP 01 041643 A (NIPPON DENSO CO LTD), 13. Februar 1989

## Beschreibung

Die Erfindung betrifft eine Vorrichtung zum Ansteuern eines piezogesteuerten Kraftstoffeinspritzventils einer Brennkraftmaschine. Sie betrifft auch ein Verfahren zum Betreiben dieser Vorrichtung.

Bei einer solchen Vorrichtung kann ein Fehlverhalten des Systems aufgrund eines Fehlers des Piezostellgliedes, der Steuerschaltung oder defekter Verbindungen durch Überwachung beispielsweise des Spannungs- und Stromverlaufs während des Ansteuervorgangs erkannt werden.

Bei einer infolge eines Fehlers der Steuerschaltung nicht erfolgenden Entladung oder bei einem Kabelbruch eines aufgeladenen Piezostellgliedes kann dieser Zustand zwar erkannt, aber nicht behoben werden, da aufgrund des hohen Widerstandes eines Piezostellgliedes die aufgebrachte Ladung relativ lange erhalten bleibt. Ein von diesem Piezostellglied betätigtes Kraftstoffeinspritzventil bleibt entsprechend lang geöffnet und spritzt zu viel Kraftstoff ein, was bis zu Motorschäden führen kann.

Aufgabe der Erfindung ist es, eine Vorrichtung zum Ansteuern eines piezogesteuerten Kraftstoffeinspritzventils dahingehend auszubilden, daß die Öffnungsdauer (Ansteuerdauer) des Piezostellgliedes auf für die zu steuernde Einrichtung ungefährliche Werte begrenzt wird. Aufgabe der Erfindung ist auch, ein Verfahren zum Betreiben dieser Vorrichtung anzugeben.

Diese Aufgabe wird erfindungsgemäß durch die Merkmale des Anspruchs 1 (Vorrichtung) und 5 (Verfahren) gelöst, indem dem Piezostellglied eine Entladevorrichtung zugeordnet ist.

Im einfachsten Fall kann als Entladevorrichtung ein Widerstand parallel zum Piezostellglied angeordnet sein, über welchen das Piezostellglied entladen wird, wenn es geladen ist und nicht mehr angesteuert wird; dieser Widerstand muß so dimensioniert sein, daß einerseits das Piezostellglied im Fehlerfall ausreichend schnell entladen werden kann, andernfalls aber der Mehrbedarf an Energie nicht zu groß wird.

Eine bessere Lösung verwendet statt des Widerstandes eine elektrische Spule. Durch den zu Ansteuerbeginn zunächst verzögert ansteigenden Strom in der Spule fällt auch der Mehrleistungsbedarf geringer aus.

Sowohl Widerstand als auch Spule entladen das Piezostellglied aber bereits ab dem Ende des Ladevorgangs, so daß eine beliebig lange fehlerfreie Öffnungsdauer des Einspritzventils damit nicht erreichbar ist.

Eine bevorzugte Ausführung nach der Erfindung ist im folgenden unter Bezugnahme auf die schematische Zeichnung am Beispiel einer Vorrichtung zum Ansteuern eines piezoelektrisch betriebenen Kraftstoffeinspritzventils näher erläutert.

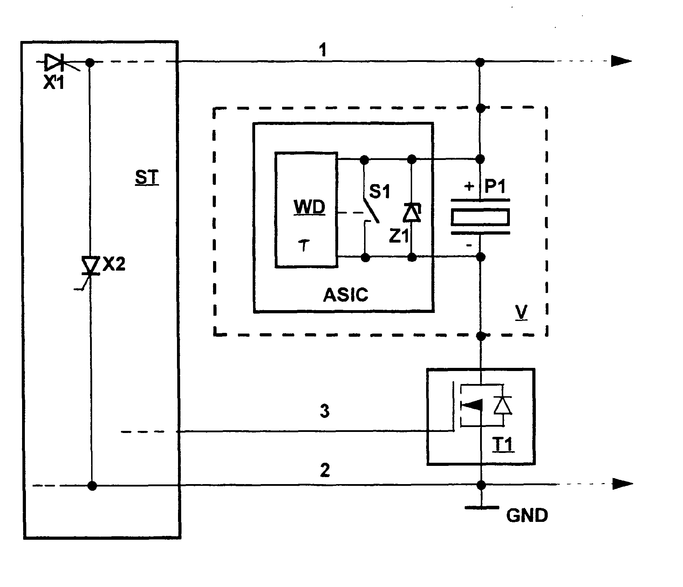

In der einzigen Figur ist ein Piezostellglied P1 eines nicht dargestellten Kraftstoffeinspritzventils in Reihe mit einem von einer Steuerschaltung ST über eine Leitung 3 gesteuerten Power-MOSFET-Schalter T1 zwischen den Leitungen 1 und 2 angeordnet. Weitere Piezostellglieder für Kraftstoffeinspritzventile weiterer Zylinder können parallel zu dieser Reihenschaltung angeordnet sein, was durch die mittels strichlierter Pfeile weitergeführten Leitungen 1 und 2 angedeutet ist. Einzelheiten einer derartigen Steuerschaltung ST sind der älteren deutschen Patentanmeldung 19652801.1 zu entnehmen.

Leitung 2 ist mit dem Bezugspotential GND der Schaltung verbunden, während über Leitung 1 das Piezostellglied P1 geladen wird, wenn ein Ladeschalter X1 gezündet wird. Über einen in der Steuerschaltung ST zwischen den Leitungen 1 und 2 angeordneten Entladeschalter X2 und den leitenden Power-MOSFET-Schalter T1 oder - in dessen nichtleitendem Zustand - über dessen Inversdiode wird das Piezostellglied P1 entladen. Die Schalter X1 und X2 sind beispielsweise Thyristorschalter.

Erfindungsgemäß ist eine Überwachungseinrichtung WD für die Öffnungsdauer ta des Piezostellgliedes P1 vorgesehen, welche parallel zum Piezostellglied P1 geschaltet ist. Die Überwachungseinrichtung WD wird von der Steuerschaltung ST zur gleichen Zeit mit Energie versorgt, während das Piezostellglied aufgeladen wird.

Mit der Aufladung des Piezostellgliedes P1 beginnt in der Überwachungseinrichtung WD ein Zeitglied T zu laufen, welches einen parallel zum Piezostellglied P1 angeordneten, als Entladevorrichtung arbeitenden, normalerweise nichtleitenden, elektronischen Schalter S1 nach einer vorgegebenen Überwachungszeit ts leitend steuert und damit das Piezostellglied P1 kurzschlußartig entlädt, wenn nicht vorher das Piezostellglied über den Entladeschalter X2 entladen wird.

Parallel zum Piezostellglied P1 ist außerdem eine Zenerdiode Z1 angeordnet, deren Katode mit dem Plusanschluß + des Piezostellgliedes verbunden ist, welche das Piezostellglied vor negativen Spannungen und vor positiven Überspannungen während des Betriebes, aber auch in ausgebautem Zustand schützt.

Vorteilhafterweise ist die Überwachungseinrichtung WD, die Entladeeinrichtung S1 (der elektronische Schalter) und die Zenerdiode Z1 als integrierte Schaltung, beispielsweise als ASIC (Application Specific Integrated Circuit) ausgeführt und innerhalb des Gehäuses des Kraftstoffeinspritzventils angeordnet. Diese Einheit aus ASIC und Kraftstoffeinspritzventil ist in der Zeichnung durch einen strichlierten Rahmen mit dem Bezugszeichen V angedeutet.

Die über ein Einspritzventil in einen Zylinder einer Brennkraftmaschine eingespritzte Kraftstoffmenge ist abhängig vom Kraftstoffdruck p und von der Öffnungsdauer ta des Einspritzventils bzw. des Piezostellgliedes. Der Kraftstoffdruck p wird abhängig von verschiedenen Parametern von einem Motorsteuergerät vorgegeben. Beim Motorstart mit noch geringem Kraftstoffdruck (z.B. p = 250bar) wird eine längere Öffnungsdauer (z.B. ta = 4,5ms) benötigt, um die erforderliche Startmenge einzuspritzen. Bei maximalem Kraftstoffdruck (z.B. pₘₐₓ = 1500bar) genügt beispielsweise eine Öffnungsdauer taₘₐₓ = 1,5ms, um die maximal erforderliche Kraftstoffmenge ins Ansaugrohr bzw. in den Zylinder zu fördern. Bei diesem Druck pₘₐₓ würde die in der Startphase erforderliche Öffnungsdauer ta = 4,5ms zu einer so großen Kraftstoffmenge im Zylinder führen, daß ein Motorschaden die Folge sein könnte.

Wird die Überwachungszeit ts auf einen Wert von beispielsweise ts = 1,8ms begrenzt, dann wird in der Startphase mit p = 250bar die erforderliche Kraftstoffmenge nicht erreicht, der Motor wird nicht anspringen.

Es wäre deshalb erforderlich, den Kraftstoffdruck p zu messen und diesem die Öffnungsdauer ta sowie die Überwachungszeit ts anzupassen. Dies würde aber eine weitere Signalleitung zu jedem Kraftstoffeinspritzventil und einen erheblichen zusätzlichen Schaltungsaufwand in der Überwachungseinrichtung WD jedes Kraftstoffeinspritzventils bedeuten.

Es ist auch möglich, die Überwachungseinrichtung WD in der Startphase auszuschalten, was beispielsweise ohne zusätzliche Leitung über ein von der Steuerschaltung ST ausgegebenes frequenzmoduliertes Signal an die Überwachungseinrichtung WD über die Leitung 1 erfolgen kann.

Die Erfindung bevorzugt ein Verfahren, welches in der Startphase der Brennkraftmaschine bei niedrigem Kraftstoffdruck für jede Zylinderfüllung wenigstens zwei Einspritzvorgänge mit einer Öffnungsdauer ta, welche die maximale Öffnungsdauer taₘₐₓ nicht überschreitet, vorsieht. Auf diese Weise kann die erforderliche Startmenge eingespritzt werden, ohne die Überwachungseinrichtung in der Startphase ausschalten zu müssen, beispielsweise mit drei oder vier Einspritzungen zu je maximal 1,5ms bei etwa 250bar.

Auf diese Weise ist es möglich, für die Überwachung der Öffnungsdauer ta des Kraftstoffeinspritzventils im gesamten Motorbetriebsbereich mit einer einzigen, konstanten Überwachungszeit ts auszukommen, die etwas größer gewählt wird als die maximale Öffnungsdauer taₘₐₓ, welche erforderlich ist, um bei maximalem Kraftstoffdruck pₘₐₓ die maximal vorgesehene Kraftstoffmenge einzuspritzen.

## Patentansprüche

1. Vorrichtung zum Ansteuern eines Kraftstoffeinspritzventils mittels eines Piezostellgliedes (P1), welches über eine Ladeeinrichtung (X1) geladen und über eine Entladeeinrichtung (X2) entladen wird,
**dadurch gekennzeichnet,**
**daß** eine dem Piezostellglied (P1) parallel geschaltete Überwachungseinrichtung (WD) vorgesehen ist,
**daß** ein dem Piezostellglied (P1) parallel geschalteter, von der Überwachungseinrichtung (WD)im Fehlerfall betätigter Entladeschalter (S1) vorgesehen ist, und
**daß** die Überwachungseinrichtung (WD) ein Zeitglied (T) aufweist, welches den Entladeschalter (S1) leitend steuert, wenn die Öffnungsdauer (ta) des Piezostellgliedes (P1) eine vorgegebene Überwachungszeit (ts) überschreitet.

2. Vorrichtung nach Anspruch 1, **dadurch gekennzeichnet, daß**
die Spannungsversorgung der Überwachungseinrichtung (WD) über die Aufladung des Piezoszellgliedes (P1) erfolgt.

3. Vorrichtung nach Anspruch 1, **dadurch gekennzeichnet, daß**
die Überwachungseinrichtung (WD), der Entladeschalter (S1) und eine parallel zum Piezostellglied (P1) angeordnete Zenerdiode (Z1) als integrierte Schaltung (ASIC) ausgebildet sind.

4. Vorrichtung nach Anspruch 3, **dadurch gekennzeichnet, daß**
die integrierte Schaltung (ASIC) innerhalb des Gehäuses des Kraftstoffeinspritzventils angeordnet ist.

5. Verfahren zum Betreiben der Vorrichtung nach einem der Ansprüche 1 bis 4, **dadurch gekennzeichnet, daß** die Überwachungszeit (ts) der Überwachungseinrichtung (WD) so bemessen ist, daß sie geringfügig größer ist als die maximale Öffnungsdauer (taₘₐₓ) des Kraftstoffeinspritzventils, welche erforderlich ist, um bei maximalem Kraftstoffdruck (pₘₐₓ) die maximale Kraftstoffmenge einzuspritzen.

6. Verfahren nach Anspruch 5, **dadurch gekennzeichnet, daß** in der Startphase der Brennkraftmaschine pro Zylinderfüllung wenigstens zwei Einspritzungen mit Öffnungsdauern ta, welche die maximale Öffnungsdauer taₘₐₓ nicht überschreiten, ausgeführt werden.

7. Verfahren zum Betreiben der Vorrichtung nach einem der Ansprüche 1 bis 4, **dadurch gekennzeichnet, daß** die Überwachungseinrichtung (WD) in der Startphase der Brennkraftmaschine ausschaltbar ist.

8. Verfahren nach Anspruch 7, **dadurch gekennzeichnet, daß** die Ausschaltung der Überwachungseinrichtung (WD) mittels eines von der Steuerschaltung (ST) ausgegebenen frequenzmodulierten Signals erfolgt.

## Claims

1. Device for controlling a fuel injection valve by means of a piezo servo component (P1), which is charged by way of a charging device (X1) and is discharged by way of a discharging device (X2),
**characterised in that**
provision is made for a monitoring facility (WD) which is connected in parallel to the piezo servo component (P1),
provision is made for a discharging switch (S1) which, in the event of a fault, is actuated by the monitoring facility (WD) and is connected in parallel to the piezo servo component (P1), and
that the monitoring facility (WD) comprises a timer (T), which conductively controls the discharging switch (S1) if the open period (ta) of the piezo servo component (P1) exceeds a predetermined monitoring time (ts).

2. Device according to claim 1, **characterised in that** the monitoring facility (WD) is supplied with power by way of charging the piezo servo component (P1).

3. Device according to claim 1, **characterised in that** the monitoring facility (WD), the discharging switch (S1) and a Zener diode (Z1) arranged in parallel to the piezo servo component (P1) are embodied as an integrated circuit (ASIC).

4. Device according to claim 3, **characterised in that** the integrated circuit (ASIC) is arranged within the housing of the fuel injection valve.

5. Method for operating the device according to one of claims 1 to 4, **characterised in that** the monitoring time (ts) of the monitoring facility (WD) is measured such that it is marginally greater than the maximum open period (taₘₐₓ) of the fuel injection valve, which is required in order to inject the maximum fuel quantity with a maximum fuel pressure (pₘₐₓ).

6. Method according to claim 5, **characterised in that** in the start phase of the internal combustion engine, at least two injections with open periods ta, which do not exceed the maximum open period taₘₐₓ are carried out per cylinder filling.

7. Method for operating the device according to one of claims 1 to 4, **characterised in that** the monitoring facility (WD) can be switched off in the start phase of the internal combustion engine.

8. Method according to claim 7, **characterised in that** the monitoring facility (WD) is switched off by means of a frequency-modulated signal which is emitted by the control circuit (ST).

## Revendications

1. Dispositif pour commander un injecteur de carburant au moyen d'un organe de commande piézo-électrique (P1) qui est chargé par l'intermédiaire d'un dispositif de charge (X1) et qui est déchargé par l'intermédiaire d'un dispositif de décharge (X2),
**caractérisé**
**en ce qu'**il est prévu un dispositif de surveillance (WD) connecté en parallèle avec l'organe de commande piézo-électrique (P1),
**en ce qu'**il est prévu un commutateur de décharge (S1) connecté en parallèle avec l'organe de commande piézo-électrique (P1), et actionné par le dispositif de surveillance (WD) en cas de défaut, et
**en ce que** le dispositif de surveillance (WD) présente un élément de temporisation (T) qui rend le commutateur de décharge (S1) conducteur lorsque la durée d'ouverture (ta) de l'organe de commande piézo-électrique (P1) dépasse un temps de surveillance prédéterminé (ts).

2. Dispositif selon la revendication 1, **caractérisé en ce que** l'alimentation en tension du dispositif de surveillance (WD) s'effectue par l'intermédiaire de la mise en charge de l'organe de commande piézo-électrique (P1) .

3. Dispositif selon la revendication 1, **caractérisé en ce que** le dispositif de surveillance (WD), le commutateur de décharge (S1) et une diode de Zener (Z1) montée en parallèle avec l'organe de commande piézo-électrique (P1), sont réalisés sous la forme d'un circuit intégré (ASIC) .

4. Dispositif selon la revendication 3, **caractérisé en ce que** le circuit intégré (ASIC) est placé dans le boîtier de l'injecteur.

5. Procédé pour faire fonctionner le dispositif selon une des revendications 1 à 4, **caractérisé en ce que** le temps de surveillance (ts) du dispositif de surveillance (WD) est calculé de manière à être un peu plus grand que la durée d'ouverture maximale (taₘₐₓ) de l'injecteur de carburant qui est nécessaire pour injecter la quantité de carburant maximale en présence de la pression de carburant maximale (pₘₐₓ) .

6. Procédé selon la revendication 5, **caractérisé en ce que**, dans la phase de démarrage du moteur à combustion interne, il se produit au moins deux injections ayant des durées d'ouverture ta qui ne dépassent pas la durée d'ouverture maximale (taₘₐₓ) .

7. Procédé pour faire fonctionner le dispositif selon une des revendications 1 à 4, **caractérisé en ce que** le dispositif de surveillance (WD) peut être déconnecté dans la phase de démarrage du moteur à combustion interne.

8. Procédé selon la revendication 7, **caractérisé en ce que** la déconnexion du dispositif de surveillance (WD) s'effectue au moyen d'un signal modulé en fréquence qui est émis par le circuit de commande (ST).
